# EUROPEAN PATENT SPECIFICATION

(11) **EP 1 537 474 B1**
(45) Date of publication and mention of the grant of the patent: **06.08.2008**
(21) Application number: 03793951.9
(22) Date of filing: 15.08.2003
(51) Int. Cl.: G06F 7/58

(54) **FEEDBACK RANDOM NUMBER GENERATION METHOD AND SYSTEM**
VERFAHREN UND SYSTEM ZUR ZUFALLSZAHLENGENERIERUNG MIT RÜCKKOPPLUNG
PROCEDE ET SYSTEME DE GENERATION DE NOMBRES ALEATOIRES A RETROACTION

(30) Priority: 06.09.2002 US 236178
(43) Date of publication of application: 08.06.2005
(73) Proprietor: NXP B.V., 5656 AG Eindhoven (NL)
(72) Inventor: HARS, Laszlo, c/o NXP Semiconductors, Surrey RH1 5HA (GB)
(74) Representative: White, Andrew Gordon
(86) International application number: PCT/IB2003/003646
(87) International publication number: WO 2004/023286

(56) References cited:
- EP-A- 0 365 930
- US-A- 5 963 104

## Description

The present invention generally relates to physical random number generators (i.e., a device that generates a bit or bits representative of a number by operating one or more components of the device in an undeterminable manner). The present invention specifically relates to an improvement of a randomness of a physical random number generator.

Physical random number generators as known in the art generate a random number bit or bits by operating one or more components of the device in an undeterminable manner. Conceptually, the undeterminable operation of the component(s) yields an unbiased random generation of the random number bit(s). In practice, the undeterminable operation of the component(s) typically yields a biased generation of the random number bit(s) due to various tolerances related to the operation of the component(s).

US5963104 discloses a digital standard cell implemented ring oscillator circuit for placement within an integrated circuit device. In one embodiment, the digital standard cell ring oscillator circuit is used in conjunction with a system for generating non-deterministic (e.g., random) output signals which can be used for data encryption. A random number generator circuit is used within the system and the standard cell ring oscillator is used to provide oscillator signals to different frequency legs of the random number generator circuit and can also be used to supply a jitter clock.

EP0365930 discloses a VLSI compatible, random number generator being highly invulnerable to cryptographic attack that is based upon a low frequency sampling of the output of a pseudo-random number generator which is operated at a varying frequency from a free-running ring oscillator. In a first embodiment, a free-running ring oscillator is used to drive a sampled linear feedback shift register. Because of the variations in power supply voltage and other circuit parameters over time, the frequency produced by the ring oscillator, when applied as the clocking input to the linear feedback shift register, causes the linear feedback shift register to operate in an aperiodic manner. The asynchronous, serial pseudo-random number output from the linear feedback shift register is sampled periodically, thereby introducing randomly occurring deviations from the pseudo-random number sequence. In a second embodiment of the invention, a variation of the free-running ring oscillator is employed as the pseudo-random number generator, by introducing into the feedback loop of the ring oscillator, an exclusive OR circuit which is connected so that the ring oscillator thereby produces a serial, pseudo-random number sequence. Additional uncertainty in the sequence of random numbers produced by the free-running pseudorandom number generator, is caused by the race condition which occurs at the inputs to the exclusive OR connected in the circuit. This can cause unpredictable skipping from a first portion of the pseudo-random number sequence to a second portion of the sequence when unbalanced signal delays occur due to variations in power supply voltage.

According to the present invention, there is provided a random number generator system as described in the appended claim 1.

Embodiments of the present invention employ a linear feedback shift register and a decimator to improve upon a biased generation of a true random bit sequence by a physical random number generator. Various aspects of the present invention are novel, non-obvious, and provide various advantages. While the actual nature of the present invention covered herein can only be determined with reference to the claims appended hereto, certain features, which are characteristic of the embodiments disclosed herein, are described briefly as follows.

One embodiment of the present invention is a random number generation system comprising a physical random number generator, a linear feedback shift register, a clock, and a decimator. The physical random number generator operates to generate one or more true random bit sequences that are communicated to the linear feedback shift register, which operates to periodically latch one or more feedback random bit sequences as a function of the true random bit sequence(s). A clock signal from the clock triggers the periodic latching of the feedback random bit sequence(s) by the linear feedback shift register. The periodic latching of one of feedback random bit sequences is communicated to the decimator, which operates to provide one or more output random bit sequences that are representative of a selective outputting of the feedback random bit sequence(s).

The foregoing form as well as other forms, features and advantages of the present invention will become further apparent from the following detailed description of the presently preferred embodiments, read in conjunction with the accompanying drawings. The detailed description and drawings are merely illustrative of the present invention rather than limiting, the scope of the present invention being defined by the appended claims.
FIG. 1 illustrates a block diagram of a first embodiment of a random number generation system in accordance with the present invention;
FIG. 2 illustrates a schematic diagram of a first embodiment of the FIG. 1 random number generation system in accordance with the present invention; and
FIG. 3 illustrates a block diagram of a second embodiment of the FIG. 1 random number generation system in accordance with the present invention.

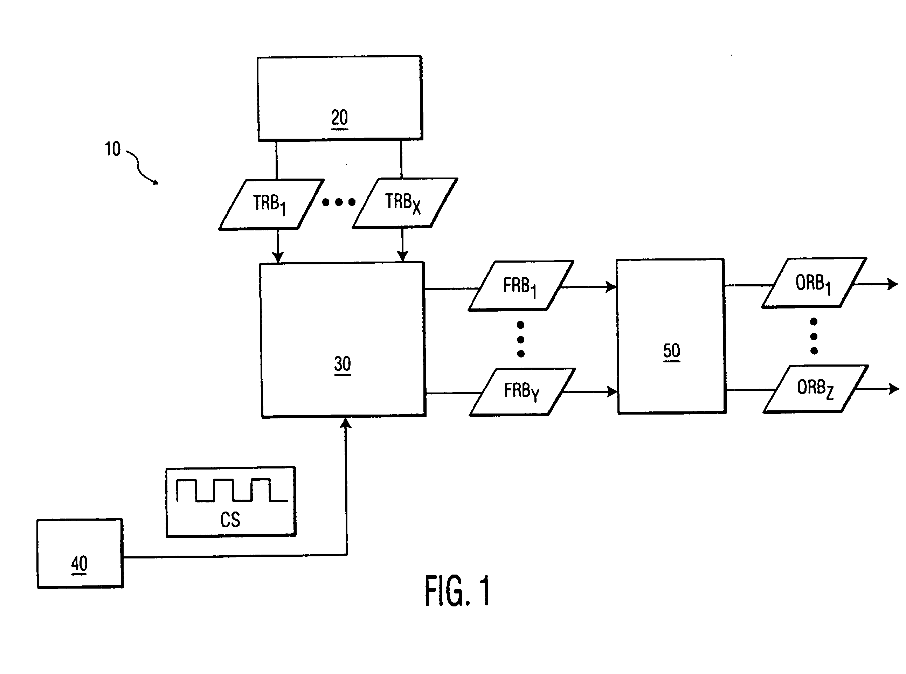

FIG. 1 illustrates a random number generation system 10 (hereinafter "system 10") comprising a physical random number generator 20 (hereinafter "PRNG 20"), linear feedback shift register 30 (hereinafter "LFSR 30"), a conventional clock 40, and a conventional decimator 50. The PRNG 20 is in communication with the LFSR 30 to thereby provide one or more true random bit sequences TRB₁-TRBₓ to the logic LFSR 30. The LFSR 30 operates to periodically latch one or more feedback random bit sequences FRB₁-FRB_{Y} as a function of the true random bit sequences TRB₁-TRB_{X}. The clock 40 is in communication with the LFSR 30 to thereby provide a clock signal CS to the LFSR 30, the clock signal CS having a predetermined operating frequency for triggering a periodic latching of the feedback random bit sequences FRB₁-FRB_{Y} by the LFSR 30. The LSFR 30 is in communication with the decimator 50 to thereby provide the feedback random bit sequences FRB₁-FRB_{Y} to the decimator 50 whereby the decimator 50 provides one or more output random bit sequences ORB₁-ORB_{z} that are representative of a selective outputting of the feedback random bit sequences FRB₁-FRB_{Y}.

The number of configurations of the PRNG 20, the LFSR 30, the clock 40, and the decimator 50 is without limit. Additionally, the aforementioned communications among the PRNG 20, the LFSR 30, the clock 40, and the decimator 50 can be achieved in numerous ways (e.g., electrically, optically, acoustically, and/or magnetically). The number of embodiments of the system 10 is therefore essentially limitless.

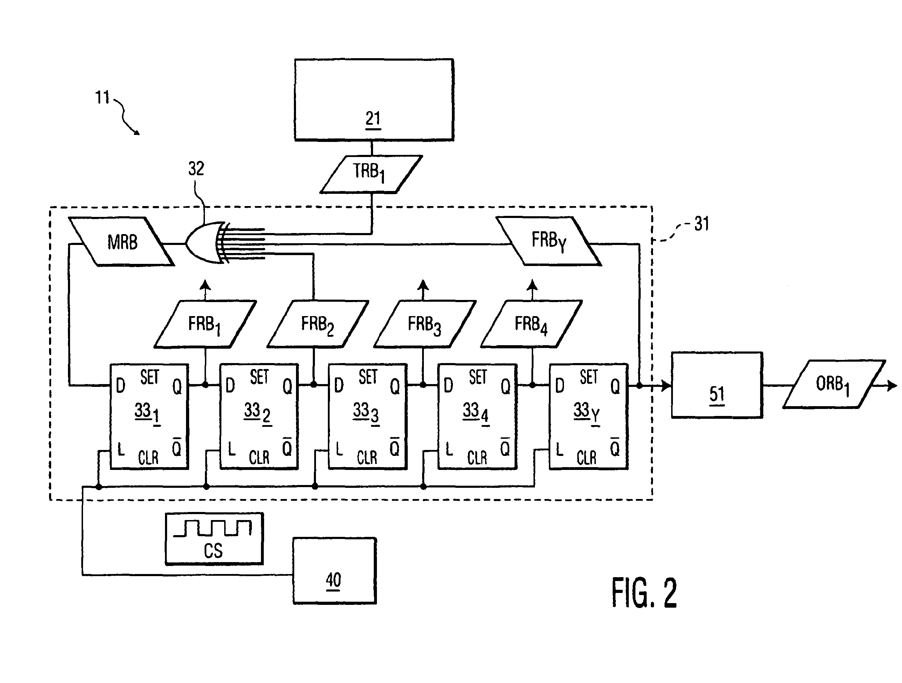

FIG. 2 illustrates a random number generation system 11 (hereinafter "system 11") as one embodiment of system 10 (FIG. 1). The system 11 includes a physical random number generator 21 (hereinafter "PRNG 21 ") and a linear feedback shift register 31 (hereinafter "LFSR 31 "). The PRNG 21 is operable to generate a true random bit sequence TRB₁ (X=1). In one embodiment, the PRNG 21 is configured in accordance with a U.S. Patent Application Serial No. US 2004/0019617 entitled "Latching Electronic Circuit For Random Number Generation". In another embodiment, the PRNG 21 is configured in accordance with a U.S. Patent US 6771104 entitled "Switching Electronic Circuit For Random Number Generation".

The LFSR 31 includes a logic circuit in the form of an XOR gate 32 having a first input electrically coupled to the PRNG 21 to thereby receive the true random bit sequence TRB₁. The LFSR 31 further includes a conventional arrangement of bi-stable latches in the form of D-type flip- flops 33_{I}-33_{Y} where a data output Q is electrically coupled to a data input D of a succeeding flip flop. Each flip-flop 33_{I}-33_{Y} periodically latches a corresponding feedback random bit sequence FRB₁-FRB_{Y} in response to a reception of the clock signal CS. The clock 40 is electrically coupled to each latch input L of the flip-flops 33_{I}-33_{Y} to thereby provide the clock signal CS to each flip-flop 33_{I}-33_{Y}. To enforce a periodic latching of the feedback random bit sequences FRB₁ - FRB_{Y} by the flip- flops 33₁-33_{Y}, a triggering transition time of the clock signal CS honors the data setup and hold times of the flip-flops 33_{I}-33_{Y}.

The data output Q of a flip-flop 33₂ is electrically coupled to a second input of the XOR gate 32 to thereby provide a feedback random bit sequence FRB₂ to the XOR gate 3 The data output Q of a flip-flop 33z is electrically coupled to a second input of the XOR gate 32 to thereby provide a feedback random bit sequence FRB_{Y} to the XOR gate 32. The data output Q of a number of the other flip-flops can be currently electrically coupled to the other illustrated inputs of the XOR gate 32 to thereby provide additional feedback random bit sequences to the XOR gate 32. The output of the XOR gate 32 is electrically coupled to the data input D of the first flip-flop 33₁ to thereby provide a mixed random bit sequence MRB to the flip-flop 33₁. The Q output of the flip-flop 32_{Y} is also electrically coupled to a decimator 51 to thereby provide the feedback random bit sequence FRB_{Y} to the decimator 51 whereby the decimator 51 provides an output random bit sequence ORB₁ (Z=1) that is representative of a selective outputting of the feedback random bit sequence FRB_{Y}. In one embodiment, the decimator 51 is a counter having a data input electrically coupled to the Q output of the flip-flop 32_{Y} whereby a selection input of the counter is controlled to implement a selective outputting of the feedback random bit sequence FRBγ.

System 11 can be varied in numerous ways to yield alternative embodiments of system 11 as would be appreciated by those having ordinary skill in the art. For example, to enhance and/or alter the bit mixing, different feedback random bit sequences among FRB₁-FRB_{Y} can be communicated to XOR gate 32. Second, only one feedback random bit sequence among feedback random bit sequences FRB₁-FRB_{Y} can be communicated to embodiments of a logic circuit having two inputs. Third, additional true random bit sequences among TRB₂-TRB_{X} (FIG. 1) and/or additional feedback random bit sequences among feedback random bit sequences FRB₁-FRB_{Y} can be communicated to embodiments of a logic circuit having four or more inputs. Fourth, additional mixed random bit sequences can be communicated to LFSR 31 and/or additional LFSRs 31. Fifth, one or more of the inverted data outputs Q of the flip-flops 33₁-33_{Y} can be utilized to generate the one or more of the feedback random bit sequences FRB₁-FRB_{Y}. Sixth, other types of bi-stable latches can be substituted for one or more of the D-type flip-flops 33₁-33_{Y}.

An operation of the system 11 will now be described herein. For purposes of the operational description, an initial state of the system 11 consists of the true random bit sequence TRB₁ and the feedback random bit sequences FRB₁-FRB_{Y} being set as 0 bits. Accordingly, the mixed bit MRB is also set as a 0 bit. Also for purposes of the operational description, the LFSR 31 consists of five (5) flip-flops 33₁-33₅ where the illustrated flip-flop 33_{Y} serves as the flip-flop 33₅. Further, the flip-flops 33₁-33₅ are designed to be triggered upon a rising edge of the clocks signal CS.

The following TABLE 1 illustrates an exemplary operation of the system 11 when the **PRNG** 20 is biased toward generating the true random bit sequence **TRB**₁ as a 1 bit:

**TABLE 1**

| **TIME** | **TRB₁** | **MRB** | **FRB₁** | **FRB₂** | **FRB₃** | **FRB₄** | **FRBs** |
|---|---|---|---|---|---|---|---|
| T₀ | 1 | 1 | 0 | 0 | 0 | 0 | 0 |
| T₁ | 1 | 1 | 1 | 0 | 0 | 0 | 0 |
| T₂ | 1 | 1 | 1 | 1 | 0 | 0 | 0 |
| T₃ | 1 | 1 | 1 | 1 | 1 | 0 | 0 |
| T₄ | 1 | 1 | 1 | 1 | 1 | 1 | 0 |
| T₅ | 1 | 1 | 1 | 1 | 1 | 1 | 1 |
| T₆ | 1 | 0 | 0 | 1 | 1 | 1 | 1 |
| T₇ | 1 | 0 | 0 | 0 | 1 | 1 | 1 |
| T₈ | 1 | 1 | 1 | 0 | 0 | 1 | 1 |
| T₉ | 1 | 1 | 1 | 1 | 0 | 0 | 1 |
| T₁₀ | 1 | 0 | 0 | 1 | 1 | 0 | 0 |
| T₁₁ | 1 | 1 | 0 | 0 | 1 | 1 | 0 |
| T₁₂ | 1 | 1 | 1 | 0 | 0 | 1 | 1 |
| T₁₃ | 1 | 1 | 1 | 1 | 0 | 0 | 1 |
| T₁₄ | 1 | 0 | 0 | 1 | 1 | 0 | 0 |
| T₁₅ | 1 | 1 | 1 | 0 | 1 | 1 | 0 |
| T₁₆ | 1 | 1 | 1 | 1 | 0 | 1 | 1 |
| T₁₇ | 1 | 0 | 0 | 1 | 1 | 1 | 0 |
| T₁₈ | 1 | 1 | 1 | 0 | 1 | 1 | 1 |
| T₁₉ | 1 | 1 | 1 | 1 | 0 | 1 | 1 |
| T₂₀ | 1 | 0 | 1 | 1 | 1 | 0 | 1 |

The following TABLE 2 illustrates another exemplary operation of the system 11 when the PRNG 20 is not very random generating the true random bit sequence TRB₁ as a periodic 0011 sequence:

**TABLE 2**

| **TIME** | **TRB₁** | **MRB** | **FRB₁** | **FRB₂** | **FRB₃** | **FRB₄** | **FRB₅** |
|---|---|---|---|---|---|---|---|
| T₀ | 0 | 0 | 0 | 0 | 0 | 0 | 0 |
| T₁ | 0 | 0 | 0 | 0 | 0 | 0 | 0 |
| T₂ | 0 | 0 | 0 | 0 | 0 | 0 | 0 |
| T₃ | 1 | 1 | 0 | 0 | 0 | 0 | 0 |
| T₄ | 1 | 1 | 1 | 0 | 0 | 0 | 0 |
| T₅ | 0 | 0 | 0 | 1 | 1 | 0 | 0 |
| T₆ | 0 | 0 | 0 | 0 | 1 | 1 | 0 |
| T₇ | 1 | 1 | 1 | 0 | 0 | 1 | 1 |
| T₈ | 1 | 1 | 1 | 1 | 0 | 0 | 1 |
| T₉ | 0 | 1 | 1 | 1 | 1 | 0 | 0 |
| T₁₀ | 0 | 1 | 1 | 1 | 1 | 1 | 0 |
| T₁₁ | 1 | 1 | 1 | 1 | 1 | 1 | 1 |
| T₁₂ | 1 | 0 | 0 | 1 | 1 | 1 | 1 |
| T₁₃ | 0 | 1 | 1 | 0 | 1 | 1 | 1 |
| T₁₄ | 0 | 1 | 1 | 1 | 0 | 1 | 1 |
| T₁₅ | 1 | 0 | 0 | 1 | 1 | 0 | 1 |
| T₁₆ | 1 | 0 | 0 | 0 | 1 | 1 | 0 |
| T₁₇ | 0 | 0 | 0 | 0 | 0 | 1 | 1 |
| T₁₈ | 0 | 1 | 1 | 0 | 0 | 0 | 1 |
| T₁₉ | 1 | 1 | 1 | 1 | 0 | 0 | 0 |
| T₂₀ | 1 | 1 | 1 | 1 | 1 | 0 | 0 |

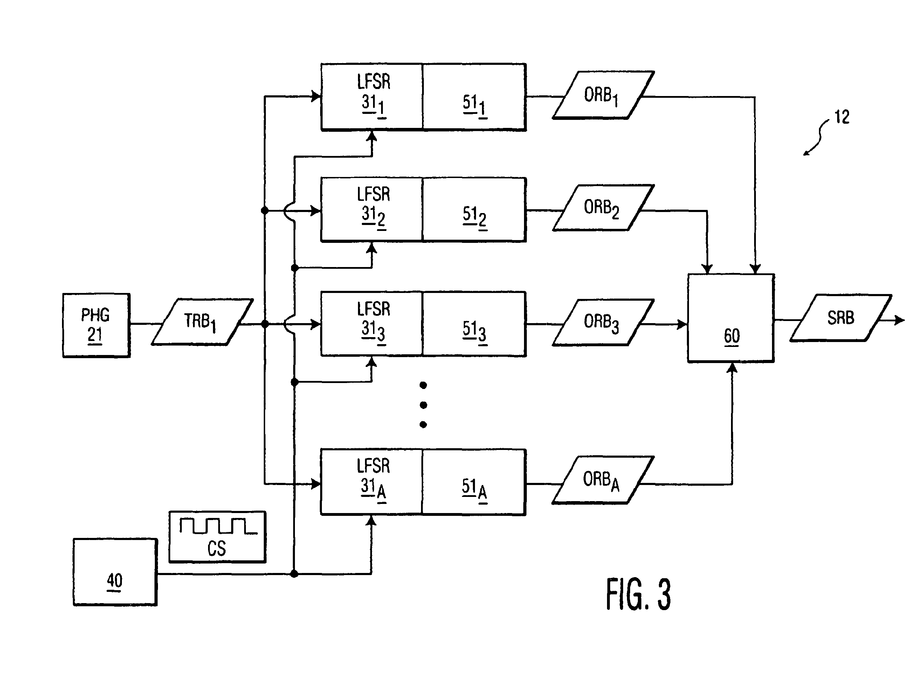

FIG. 3 illustrates a random number generation system 12 (hereinafter "system 12") as another embodiment of system 10 (FIG. 1). The system 12 employs the PRNG 21, the clock 40, a plurality of LFSRs 31₁-31_{A}, a plurality of decimators 51₁-51_{A}, and a logic circuit 60 (e.g., a multi-input XOR gate). The decimators 51₁-51_{A} are in communication with logic circuit 60 to thereby provide a plurality of output random bit sequences ORB₁-ORB_{A} to the logic circuit 60. In response thereto, the logic circuit 60 will provide a system random bit sequence SRB that is sufficiently insensitive to any of the output random bit sequences ORB₁-ORB_{A} being provided as a constant bit stream. As long as any one of the corresponding pairs of LFSRs 31₁-31_{A} and decimators 51₁-51_{A} produce random bits, the resulting system random bit sequence SRB will also be random. On a VLSI chip, integrating several hundreds of different LFSRs 31₁-31_{A} and decimators 51₁-51_{A} is feasible and the resulting bit stream will be highly unpredictable.

System 12 can be varied in numerous ways to yield alternative embodiments of system 12 as would be appreciated by those having ordinary skill in the art. For example, alternative to each LFSR 31₁-31_{A} receiving the clock signal CS, additional clocks can be employed within an alternative embodiment of system 12 to provide two or more clock signals of different frequencies with each clock signal being strategically provided to selected LFSRs 31₁-31_{A}. Second, additional PRNGs 21 can be employed within an alternative embodiment of system 12 with each true random bit sequence being strategically provided to the selected LFSRs 31₁-31_{A}. Third, one or more of the decimators 51₁-51_{A} can be in communication with two or more of the LFSRs 31₁-31_{A}. Fourth, the decimators 51₁-51_{A} can be removed and the LFSRs 31₁-31_{A} can be in communication with the logic circuit 60 whereby the system random bit sequence SRB is a function of selected feedback random bit sequences from the LFSRs 31₁-31_{A}.

While the embodiments of the present invention disclosed herein are presently considered to be preferred, various changes and modifications can be made without departing from the spirit and scope of the present invention. The scope of the present invention is indicated in the appended claims.

## Claims

1. A random number generator system (10, 11), comprising:
a physical random number generator (20, 21) operable to generate one or more true random bit sequences (TRB);
**characterised in that** said system further comprises:
a linear feedback shift register (30, 31) operable to periodically latch one or more feedback random bit sequences (FRB) that are functions of the one or more true random bit sequences (TRB); and
a clock (40) operable to provide a clock signal (CS) having a predetermined operating frequency for triggering a periodic latching of the one or more feedback random bit sequences (FRB) by said linear feedback shift register (30, 31).

2. The random number generation system of claim 1, further comprising:
a decimator (51) operable to provide one or more output random bit sequences (ORB) that are representative of a selective outputting of the one or more feedback random bit sequences (FRB).

3. The random number generation system of claim 1 or 2, wherein said linear feedback shift register (31) includes
a logic circuit (32) operable to generate one or more mixed random bit sequences (MRB) in response to a reception of the true random bit sequence (TRB) and a reception of a first feedback random bit sequence (FRB) of the one or more feedback random bit sequences (FRB), and
at least one bi-stable latch (33) operable to generate the one or more feedback random bit sequences (FRB) in response to a reception of the one or more mixed random bit sequences (MRB) and the clock signal (CS).

4. The random number generation system of claims 1, 2 or 3, further comprising:
a logic circuit (60) operable to provide a system random bit sequence (SRB) as a function of the one or more output random bit sequences (ORB).

## Patentansprüche

1. Zufallszahlengeneratorsystem (10, 11), umfassend:
einen physikalischen Zufallszahlengenerator (20, 21), der so betreibbar ist, dass er eine oder mehrere echte Zufallsbitsequenzen (TRB) erzeugt;
**dadurch gekennzeichnet, dass** das System ferner umfasst:
ein lineares Rückkopplungsschieberegister (30, 31), das so betreibbar ist, dass es periodisch eine oder mehrere Rückkopplungszufallsbitsequenzen (FRB) zwischenspeichert, die Funktionen der einen oder der mehreren echten Zufallsbitsequenzen (TRB) sind; und
einen Taktgeber (40), der so betreibbar ist, dass er ein Taktsignal (CS) mit einer vorgegebenen Betriebsfrequenz bereitstellt, um eine periodische Zwischenspeicherung der einen oder der mehreren Rückkopplungszufallsbitsequenzen (FRB) mittels des linearen Rückkopplungsschieberegisters (30, 31) auszulösen.

2. Zufallszahlengeneratorsystem nach Anspruch 1, ferner umfassend:
einen Dezimator (51), der so betreibbar ist, dass er eine oder mehrere Ausgangszufallsbitsequenzen (ORB) bereitstellt, die repräsentativ für eine selektive Ausgabe der einen oder der mehreren Rückkopplungszufallsbitsequenzen (FRB) sind.

3. Zufallszahlengeneratorsystem nach Anspruch 1 oder 2, wobei das lineare Rückkopplungsschieberegister (31) enthält:
eine Logikschaltung (32), die so betreibbar ist, dass sie eine oder mehrere gemischte Zufallsbitsequenzen (MRB) in Reaktion auf einen Empfang der echten Zufallsbitsequenz (TRB) und einen Empfang einer ersten Rückkopplungszufallsbitsequenz (FRB) der einen oder der mehreren Rückkopplungszufallsbitsequenzen (FRB) erzeugt, und
wenigstens einen bistabilen Signalspeicher (33), der so betreibbar ist, dass er die eine oder die mehreren Rückkopplungszufallsbitsequenzen (FRB) in Reaktion auf einen Empfang der einen oder der mehreren gemischten Zufallsbitsequenzen (MRB) und des Taktsignals (CS) erzeugt.

4. Zufallszahlengeneratorsystem nach einem der Ansprüche 1, 2 oder 3, ferner umfassend:
eine logische Schaltung (60), die so betreibbar ist, dass sie eine Systemzufallsbitsequenz (SRB) als eine Funktion der einen oder der mehreren Ausgangszufallsbitsequenzen (ORB) bereitstellt.

## Revendications

1. Système de générateur de nombres aléatoires (10, 11), comprenant :
- un générateur de nombres aléatoires physiques (20, 21) utilisable pour engendrer une ou plusieurs séquences aléatoires de binaires réelles (TRB) ;
**caractérisé en ce que** ledit système comprend en outre :
- un registre à décalage à rétroaction linéaire (30, 31) utilisable pour verrouiller périodiquement une ou plusieurs séquences aléatoires de binaires de rétroaction (FRB) qui sont des fonctions d'une ou plusieurs séquences aléatoires de binaires réelles (TRB) ; et
- une horloge (40) utilisable pour fournir un signal d'horloge (CS) ayant une fréquence de fonctionnement prédéterminée pour déclencher un verrouillage périodique d'une ou plusieurs séquences aléatoires de binaires de rétroaction (FRB) par ledit registre à décalage à rétroaction linéaire (30, 31).

2. Système de génération de nombres aléatoires selon la revendication 1, comprenant en outre :
- un décimateur (51) utilisable pour fournir une ou plusieurs séquences aléatoires de binaires d'émission (ORB) qui sont représentatives d'une émission sélective d'une ou plusieurs séquences aléatoires de binaires de rétroaction (FRB).

3. Système de génération de nombres aléatoires selon la revendication 1 ou 2, dans lequel ledit registre à décalage à rétroaction linéaire (31) comprend :
- un circuit logique (32) utilisable pour développer une ou plusieurs séquences aléatoires de binaires mixtes (MRB) en réponse à une réception de la séquence binaire aléatoire réelle (TRB) et à une réception d'une première séquence binaire aléatoire de rétroaction (FRB) d'une ou plusieurs séquences aléatoires de binaires de rétroaction (FRB), et
- au moins une bascule bistable (33) utilisable pour développer une ou plusieurs séquences aléatoires de binaires de rétroaction (FRB) en réponse à une réception d'une ou plusieurs séquences aléatoires de binaires mixtes (MRB) et du signal d'horloge (CS).

4. Système de génération de nombres aléatoires selon la revendication 1, 2 ou 3, comprenant en outre :
- un circuit logique (60) utilisable pour fournir une séquence binaire aléatoire de système (SRB) en tant que fonction d'une ou plusieurs séquences aléatoires de binaires d'émission (ORB).
